Europäisches Patentamt

European Patent Office

Office européen des brevets

(11) Publication number: 0 494 309 A1

## EUROPEAN PATENT APPLICATION
### published in accordance with Art. 158(3) EPC

(21) Application number: 91910191.5

(22) Date of filing: 31.05.91

(86) International application number: PCT/JP91/00736

(87) International publication number: WO 91/19322 (12.12.91 91/28)

(51) Int. Cl.5: H01L 29/792

(30) Priority: 01.06.90 JP 143564/90

(43) Date of publication of application: 15.07.92 Bulletin 92/29

(84) Designated Contracting States: DE FR GB IT NL

(71) Applicant: SEIKO EPSON CORPORATION
4-1, Nishishinjuku 2-chome
Shinjuku-ku Tokyo 163(JP)

(72) Inventor: KATO, Koji
3-5, Owa 3-chome
Suwa-shi, Nagano-ken 392(JP)

(74) Representative: Ouinterno, Giuseppe et al
c/o Jacobacci-Casetta & Perani S.p.A. Via Alfieri, 17
I-10121 Torino(IT)

### (54) METHOD OF MANUFACTURING SEMICONDUCTOR DEVICE.

(57) A method for manufacturing a memory using a ferroelectric film, whereby a ferroelectric substance memory in which information can be rewritten many times and which has good characteristics in breakdown voltage and leakage current, etc., is obtained through forming a polysilicon film between a diffusion layer of high impurity concentration to be a source of drain region and an electrode of a ferroelectric substance film electrode. A contact hole is made in an interlayer insulation film (111) on the diffusion layer of a high impurity concentration (103) to be the source or drain region formed on a semiconductor substrate. After a polysilicon layer (106) is epitaxially grown thereon, the polysilicon film is left in the contact hole by performing an entire-face etching-back. Then, a lower electrode (107), a ferroelectric substance layer (108) and an upper electrode wiring (109) are formed. Since the step of the contact hole is made gentle by the polysilicon layer, the film thickness of the ferroelectric is uniformalized and the characteristics of the memory is improved.

Fig. 1    ( c )

## Technical Field

The invention relates to a method of manufacturing a memory, particularly an electrically rewritable non-volatile memory, with the use of a ferroelectric.

## Background Art

As a prior semiconductor non-volatile memory, use is generally made of a MIS-type transistor by using such a phenomenon that the surface potential of a silicon substrate is modulated by injecting charge from the silicon substrate into a trap or floating gate in an insulating gate, and the semiconductor non-volatile memory is practically used as EPROM (ultraviolet erasable non-volatile memory), EEPROM (electrically rewritable non-volatile memory) and the like.

However, these non-volatile memories have such disadvantages that an information rewriting voltage is high such as around 20 V, rewriting time is very long (for example, several tens msec in case of EEPROM) and the like. Moreover, information rewriting number is about $10^2$ times, which is very few and a problem for repetitive use.

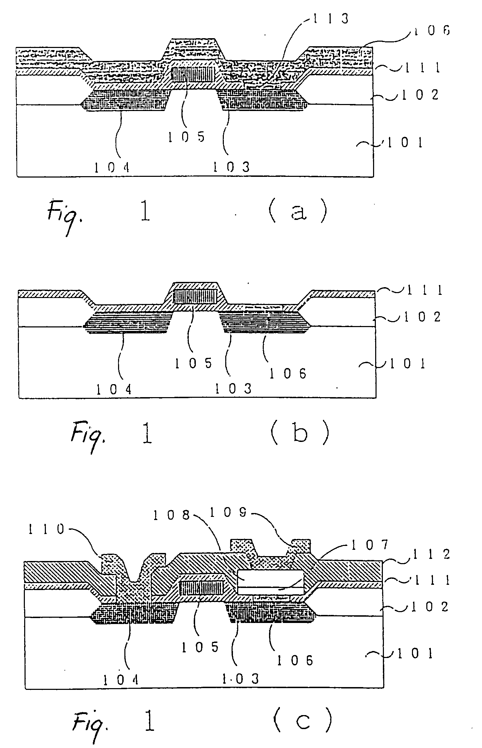

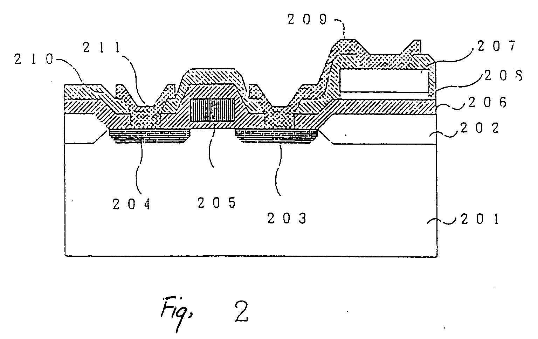

A non-volatile memory with the use of a ferroelectric which polarization is electically reversible is substantially the same in writing time and reading time in principle, and its polarization is maintained even after an electric source is cut off, so that this non-volatile memory has a possibility as an ideal non-volatile memory. With respect to such non-volatile memory with the use of a ferroelectric, U.S. Patent No. 4,149,302 proposes a structure integrating a capacitor consisting of a ferroelectric on a silicon substrate, and U.S. Patent No. 3,832,700 proposes a non-volatile memory arranging a ferroelectric film in the gate portion of a MIS-type transistor. Moreover, there is recently proposed an IEDM '87, pp.850-851, a non-volatile memory having a structure laminating in an MOS-type semiconductor device as shown in Fig. 2. In Fig. 2, (201) is a P-type Si substrate, (202) is an element separating LOCOS oxide film, (203) is an N-type diffusion layer as a source, and (204) is an N-type diffusion layer as a drain. (205) is a gate electrode, and (206) is an interlayer insulating film. (207) is a ferroelectric film forming a capacitor sandwiched by electrodes (208) and (209). (210) is a second interlayer insulating film, and (211) is an Al as a wiring electrode. In the structure laminated on the upper portion of a MOS-type semiconductor device, wiring between the electrode of the ferroelectric film and the high concentration diffusion layers as source and drain on the semiconductor substrate should be carried out by using Al and the like as shown in Fig. 3, and an element area is increased. The invention is to solve these problems, and aims to provide a semiconductor device, particularly a non-volatile memory, having less increase of an element area, low cost, and excellent information rewriting times.

## Disclosure of the Invention

A method of manufacturing a semiconductor device according to the invention comprises the steps of forming a polysilicon film between either one electrode (hereinafter referred to as "lower electrode") of electrodes formed on a high concentration diffusion layer by sandwiching a ferroelectric film and sandwiching said ferroelectric film and the high concentration diffusion layer formed on said semiconductor substrate by a chemically vapor phase growing method, and etchbacking said polysilicon film.

## Brief Discription of the Drawings

Figs. 1(a)-(c) are cross sections showing the essential steps in one embodiment of a semiconductor device according to the invention.

Fig. 2 is a cross section of a non-volatile memory according to the prior art.

## Best Mode for carrying out the Invention

Figs. 1(a)-(c) are cross sections showing the essential steps in one embodiment of a semiconductor device according to the invention. A method of manufacturing a semiconductor device according to the invention is explained by referring to Fig. 1 as follows. For the sake of explanation, an embodiment using an Si substarte and an N-channel transistor is explained.

(101) is a P-type Si substrate with the use of a wafer of specific resistance such as 20 ohm.cm. (102) is an element separating insulating film, and an oxide film is formed into 6000 Å by a LOCOS method as a prior technique. (103) is an N-type diffusion layer as a source formed by ion injecting phosphorus at 80 KeV $5\times10^{15}$ cm$^{-2}$. (104) is an N-type diffusion layer as a drain and simultaneously formed with (103). (105) is a gate electrode and uses phosphrus-doped polysilicon. (111) is a first interlayer insulating film, and a contact hole is formed by forming 4000 Å of phosphorus glass by a chemically vapor phase growing method and thereafter using a prior photo exposure technique. (106) is a polysilicon film as a main object of the invention, and formed into 10000 Å by a chemically vapor phase growing method. In this case, it is preferable to make a thickness of the polysilicon film at least more than twice the depth of the contact hole (Fig. 1(a)). Moreover, said polycilison film is made the same thickness as the depth of said contact hole by etch-backing the whole surface (Fig. 1(b)). In this case, when said polysilicon film is thicker than the depth of said contact hole, the remaining polysilicon film other than said contact hole is etched by an exposure technique.

(107) is one of electrodes of a ferroelectric film, and formed by sputtering Pt, Pd and the like. (108) is $PbTiO_3$, PZT (mixed crystal of $PbTiO_3$ and $PbZrO_3$), PLZT (La-doped PZT) and the like as a ferroelectric film, and formed by a sputtering method.

(109) is another electrode of the ferroelectric film, and uses the same Al as the wiring electrode of (110) here. (112) is a second interlayer insulating film, and phosphorus glass is formed into 4000 Å by a chemically vapor phase growing method (Fig. 1(c)).

According to the manufacturing method shown in Fig. 1, a ferroelectric film is directly formed on a high concentration diffusion layer, and a lower electrode is directly made into contact with the high concentration diffusion layer via a polysilicon film, so that the upper electrode only requires wiring, and integration having a small element area is possible.

In Fig. 1, in case of no polysilicon film of (106), a ferroelectric film becomes partly thin by a step difference in a contact hole, and as a result, information rewriting number is $10^5$ times and write-in/read-out becomes impossible, and further, a breakdown voltage was 12 V. Contrary to the above, when a polysilicon film of (106) is formed between an electrode of (107) and a high concentration diffusion layer by a chemically vapor phase growing method and etch-backed as in the invention, polysilicon is well adhered to ease the step difference of a contact hole, write-in/read-out becomes possible up to $10^{10}$ times by uniformly forming the thickness of a ferroelectric film, and a breakdown voltage is improved to 30 V.

The non-volatile memory is mainly explained in the above, but it is a matter of course that the invention can be applied to a memory (DRAM and the like) with the aid of a large specific dielectric constant of the ferroelectric.

**Industrial Applicability**

The invention comprises the steps of forming a polysilicon film between either one of electrodes formed by sandwiching a ferroelectric film and a high concentration diffusion layer by a chemically vapor phase growing method and etch-backing said polysilicon film, so as to ease the step difference of a contact hole, and has effect of increasing no element area and integration of a ferroelectric film having good electrical characteristics by uniformly forming the film thickness of the ferroelectric film.

**Claims**

1. A method of manufacturing a semiconductor device integrating a ferroelectric film on the same semiconductor substrate as that formed an active element therein via electrodes formed by sandwiching the ferroelectric film, comprising the step of

    forming a polysilicon film between an electrode (hereinafter referred to as "lower electrode") to be connected to a high concentration diffusion layer formed on said semiconductor substrate among electrodes formed for sandwiching said ferroelectric film and said high concentration diffusion layer.

2. A method of manufacturing a semiconductor device as claimed in claim (1), wherein said polysilicon film is formed by a step by a chemically vapor phase growing method and a step of totally etch-backing said polysilicon film.

Fig. 1 (a)

Fig. 1 (b)

Fig. 1 (c)

Fig. 2

# INTERNATIONAL SEARCH REPORT

International Application No PCT/JP91/00736

## I. CLASSIFICATION OF SUBJECT MATTER (if several classification symbols apply, indicate all) 6

According to International Patent Classification (IPC) or to both National Classification and IPC

Int. Cl$^5$  H01L29/792

## II. FIELDS SEARCHED

| Minimum Documentation Searched 7 | |
|---|---|
| Classification System | Classification Symbols |
| IPC | H01L29/792 |

Documentation Searched other than Minimum Documentation
to the Extent that such Documents are Included in the Fields Searched 8

| | |
|---|---|
| Jitsuyo Shinan Koho | 1959 - 1990 |
| Kokai Jitsuyo Shinan Koho | 1971 - 1990 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| A | JP, A, 01-251760 (Seiko Epson Corp.), October 6, 1989 (06. 10. 89) | 1-2 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| August 13, 1991 (13. 08. 91) | September 9, 1991 (09. 09. 91) |
| International Searching Authority | Signature of Authorized Officer |
| Japanese Patent Office | |

Form PCT/ISA/210 (second sheet) (January 1985)